Europäisches Patentamt

European Patent Office

Office européen des brevets

(11) Publication number: **0 185 967**
**A2**

## EUROPEAN PATENT APPLICATION

(21) Application number: **85115225.6**

(22) Date of filing: **30.11.85**

(51) Int. Cl.⁴: **C 23 C 18/18**

(30) Priority: **10.12.84 US 679828**

(43) Date of publication of application:
**02.07.86 Bulletin 86/27**

(84) Designated Contracting States:
**CH FR IT LI NL SE**

(71) Applicant: KOLLMORGEN TECHNOLOGIES
CORPORATION
Suite 300 2001 Bryan Tower
Dallas Texas 76201(US)

(72) Inventor: DeLuca, Michael A.
1534 Claas Avenue
Holbrook, NY 11741(US)

(72) Inventor: McCormack, John F.
116 Milburn Lane
Roslyn Heights, NY 11577(US)

(72) Inventor: Oleske, Peter J.
97 Maple Road
Rocky Point, NY 11778(US)

(74) Representative: Königseder, geb. Egerer, Claudia
Zugspitzstrasse 65
D-8104 Grainau(DE)

(54) Process for avoiding blister formation in electroless metallization of ceramic substrates.

(57) A process for avoiding blister formation between a metal layer which is electrolessly deposited on a surface of a ceramic substrate is claimed. The substrate is adhesion promoted with an alkali metal composition containing between 0.35 and 0.9 mole fraction alkali metal compound and water at a temperature equal to or in excess of 140°C and not exceeding 300°C, and preferably 240°C, for a time period between 1 and 200 minutes. Thereafter, the adhesion promoted ceramic surface is rendered receptive to electroless metal deposition and is coated free of blisters using an electroless metal deposition bath with an adherent, metal layer having a thickness greater than 5 μm.

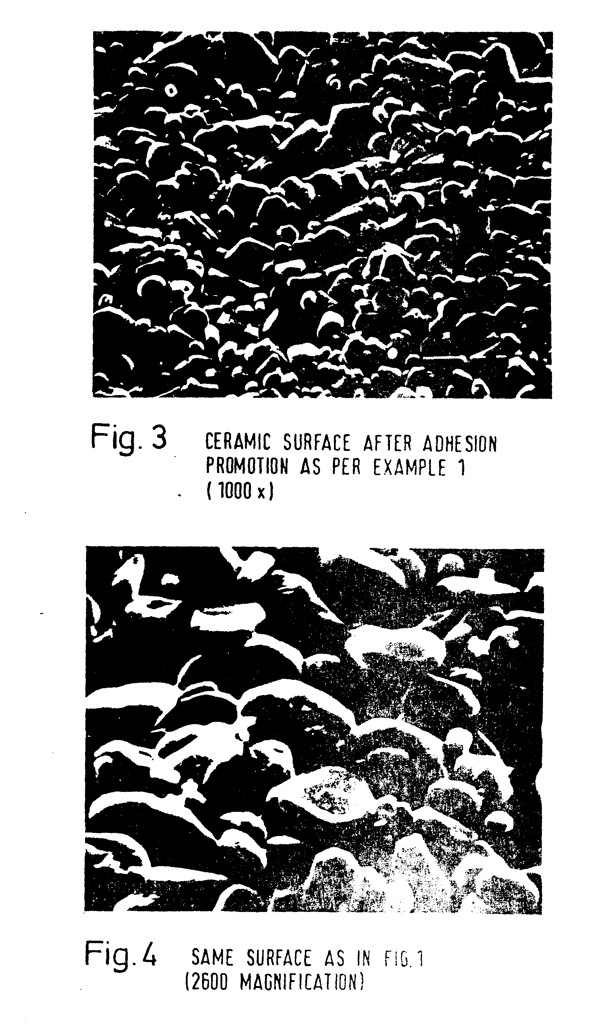

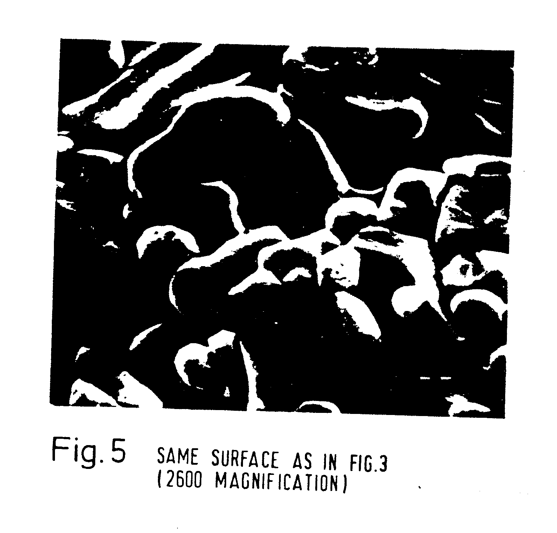

Fig. 5  SAME SURFACE AS IN FIG.3
(2600 MAGNIFICATION)

EP 0 185 967 A2

Croydon Printing Company Ltd

The invention relates to metallized ceramic articles and to a metallized conductor pattern directly and adherently bonded onto a surface of a ceramic substrate, and an improved process for producing the same. More particularly, the invention relates to a process for electrolessly depositing a securely adhering, blisterfree, thick layer of metal on a surface of a ceramic substrate.

Metallized conductor patterns or uniform metal layers on ceramic substrates have been widely used in the electronic industry. Ceramics have been metallized by high cost processes such as the ones using fused metal-glass pastes or by thin film vacuum deposition techniques. Attempts to reproducibly make circuit patterns by direct electroless deposition have not been successful due to poor adhesion of the metal films to the substrate and non-reproducible and non-uniform coverage.

Printed circuits on ceramics including alumina were described as early as 1947. One type, known as a thin film circuit, consists of a thin film of metal deposited on a ceramic substrate by one of the vacuum plating techniques.

Due to their high cost, thin film circuits have been limited to specialized applications such as high frequency and military applications where a high pattern resolution is vital.

Another type of printed circuit, known as a thick film circuit, consists of circuit conductors composed of a metal and glass film fired on a ceramic substrate. Conductors in thick film circuits have only 30 to 60% of the conductivity of the respective pure metal conductors. However, high conductivity of pure metal conductors is needed to provide interconnections for high speed logic circuits which cannot be achieved with low conductive thick film circuits.

The minimum conductor width and the minimum space between conductors which can be obtained by screen printing and firing under special high quality procedures is 125 $\mu$m and

200 μm, respectively. Under normal production conditions, these minima are 200 and 250 μm, respectively.

In the thick film multilayer process, a first layer of metal powder and glass frit is printed on a ceramic substrate and fired, typically at 850°C, in a furnace. Then, an insulating dielectric layer is screened over the conductor pattern, leaving exposed only the points at which contact is made to the next layer of metallization. This dielectric pattern is also fired at 850°C. Then, a second dielectric layer is printed and fired. Two layers of dielectric must be printed and fired to ensure that there are no pinholes. After the two layers of dielectric have been printed and fired, the next conductor layer is printed and fired making contact to the lower conductor layer as necessary through the openings left in the dielectric layers.

For two layers of metal patterns, the substrate will be printed four times and fired at 850°C seven times.

By the process of the invention, the same connectivity as a three or four layer film multilayer ceramic can be achieved by a two-sided, plated-through hole, conductor pattern.

Attempts have been made to directly bonding pure metal conductors to ceramic substrates including alumina in order to achieve high conductivity for ceramic based circuit patterns. Compare US-PS 3 744 120 and 3 766 634. In "Solid State Technology" 18/5, 43 (1975) and US-PS 3 994 430 is described a process for bonding copper sheets to alumina by heating the copper in air to form an oxide film on its surface. The treated copper sheet is bonded by the agency of this film to alumina at a temperature between 1065°C and 1075°C in a nitrogen furnace. In order to obtain well adhered copper foil without blisters, 1) the copper foil must be carefully oxidized to provide a black surface; 2) the copper oxide thickness must be carefully controlled; 3) the amount of oxygen in the copper foil must be controlled; 4) the oxygen content of the nitrogen furnace must be maintained at a controlled level to maintain a very moderately oxidizing atmosphere; and 5) the temperature must be controlled within one percent. This carefully controlled, high temperature operation is difficult and expensive to tool for, to operate and to control. If the aforementioned, extremely stringent controls are not maintained, blisters and other adhesion failures between the copper foil and the substrate are apparent. In spite of the difficult operating conditions, this process is being used in commercial applications because of the need for the metallized product.

Although the above described systems are commercially used, the need for direct, simple metallization of ceramics with a layer or pattern of a pure metal conductor, such as copper, has prompted a continuous series of patents and proposed processes. See, e.g., DE-PS 20 04 133, 24 53 192, 24 53 277 and 25 33 524.

Other processes for producing printed circuit patterns on ceramic substrates are disclosed in US-PS 3 772 056; 3 772 078; 3 907 621; 3 925 578; 3 930 963; 3 959 547; 3 998 802 and 3 994 727. However, there is no teaching in all these patents how to adhesion promote ceramic surfaces. US patent 3 296 012 discloses a process for producing a microporous surface for electrolessly plating alumina.

Attempts to simply apply electroless metallization directly to ceramic substrates have continually been tried and never been commercially successful. Toxid and corrosive materials such as hydrogen fluoride, were tried to allow the direct bonding of electrolessly formed metal deposits to ceramics without the use of firing temperatures. See, e.g., J. Electrochem. Soc., 120, 1518 (1973). However, the hydrofluoric etch gave poor bond strength due to the resulting surface topography.

US-PS 4 428 986 discloses a process for direct autocatalytic plating of a metal film on beryllia. The process comprises uniformly roughening the surface by immersing

- 4 -

0185967

the beryllia in a 50% sodium hydroxide solution at 250°C for 7 to 20 minutes, rinsing with water, etching the beryllia with fluoboric acid for 5 to 20 minutes to attack the glass alloying constituents, rinsing with water, immersing the beryllia an a solution of 5 g/l stannous chloride and 3N hydrochloric acid, rinsing with water, followed by treating with 0.1 g/l palladium chloride solution, rinsing with water, and then electrolessly plating nickel on the beryllia. However, the etching step removes the silica and magnesium from the grain boundaries of the beryllia, thereby weakening the beryllia surface. As a result, thisprocess was able to achieve only 250 psi (1.7 MPa) bond strength before the beryllia substrate broke. This bond strength is only about a third of the bond strength normal in thick film type circuits and for many purposes not adequate.

US-PS 3 690 921 discloses the application of a concentrated sodium hydroxide solution to the surface of a ceramic substrate. The ceramic substrate is heated to drive off the solvent (water) and is heated further to melt the sodium hydroxide and etch the ceramic surface. The molten sodium hydroxide has a tendency to coalesce on, and not uniformly wet, the ceramic surface. Smooth ceramic surfaces, e.g., having a surface roughness below 0.13 µm are, therefore, difficult to completely wet with molten sodium hydroxide. As a result, uneven etching of ceramic surfaces, particularly smooth ceramic surfaces, results with the use of molten sodium hydroxide. In the best cases, when a metal is subsequently bonded to the ceramic surface, the bond strength is uneven across the ceramic surface. In the worst case, there is no adhesion of metal in some areas of the ceramic surface, or even no metal deposit because there was no adhesion of the electroless plating catalyst.

In an alternate embodiment of the same patent, the ceramic substrate is directly immersed in a container of molten alkali metal hydroxide for 10 to 15 minutes at a temperature of between 450°C and 500°C to etch the ceramic surface.

Operation of the immersion procedure is difficult because 1) the immersion of a ceramic article into a container of molten sodium hydroxide may crack the article due to thermal shock, thus resulting in low yields of useful product; and 2) a thick crust of carbonate forms on the surface of the molten sodium hydroxide impeding the manufacturing process. Thus, the processes of the prior art did not achieve commercial production.

The trend in ceramic printed circuit manufacturing is toward smoother and more uniform surface topography. A smooth surface provides better conductor definition and improved parameters for propagation of very high frequency signals at the substrate conductor interface.

Unfortunately, the smoother the ceramic surface, the lower the net surface energy. As a result, the alkali metal compound does not completely wet such smooth ceramic surfaces having surface roughnesses of, e.g., 0.6 μm. During the fusion step, the liquid caustic tends to coalesce into one or more areas on the surface of the substrate to achieve lower net surface energy. This results in a less than uniform surface etch and thus defective surface texture.

Total immersion of an alumina substrate in molten sodium hydroxide gives a uniform, but sever surface etch. The severe surface etch results in a rough surface which does not permit fine conductor line resolution. In addition, such total immersion also tends to weaken the intrinsic structural integrity of the ceramic substrate resulting in cracks, especially in ceramic substrates provided with drilled holes.

As the purity of the ceramic increases, the surface also becomes smoother. Attempts to etch, for example, 99.5% pure electronic grade alumina by the procedures described in the prior art, tend to result in a surface that is highly non-uniform.

Since 99.5% electronic grade alumina is normally used for microwave circuitry, surface roughness caused by deep etching must be avoided in order not to disturb the microwave signal propagation. 89 to 96% pure electronic grade alumina shows less of this problem, although it frequently is difficult to achieve satisfactory results on a manufacturing scale employing prior art processes.

quaternary amine surfactants and detergent blends containing cationic wetting agents have been used for about 20 years to prepare plastic substrates for reception of palladium catalysts for electroless plating. However, these surfactants have not been suggested for preparing ceramic substrates for reception of palladium catalysts for electroless plating. Moreover, commercially available, alkaline cleaner-conditioners which are used to prepare plastic substrates for reception of palladium catalysts for electroless plating have not been found to be effective in preparing ceramic substrates.

It is an object of the invention to provide a process for electrolessly plating a metal layer to a ceramic substrate to obtain excellent surface coverage and a bond strength of at least 3 MPa, preferably at least 5 MPa.

Another object of this invention is to produce an electrolessly plated metal layer on a ceramic substrate which may be used for fine line circuit applications with highly pure metal conductors.

A further object of the invention is to provide and improved process for adhesion promoting surfaces of ceramic substrates for adherent metallization.

It is also an object of the invention to provide an electrolessly deposited, direct bonded conductor pattern having excellent adhesion to a ceramic substrate and a process for producing the metal coated ceramic substrate.

Still another object of the invention is to provide a reliable process for adherently metallizing the surfaces of a ceramic substrate while avoiding blister formation.

A still further object of the invention is to provide a two-sided plated ceramic substrate with a through hole conductor pattern and a conductor density comparable to a three or four layer, thick film multilayer ceramic.

In US Application Serial No. 607,874 of May 10, 1984, is described an improvement in a process for metallizing ceramic substrates which includes treating the surface to adherently receive metal and depositing metal on the treated surface. The improved method comprises treating the surface with a melt comprising one or more alkali metal compound(s); and, in a later step, exposing the surface to an acidic halide solution containing one or more halide(s) selected from the group consisting of chlorides, bromides and iodides in an amount greater than 0.5 moles halide per liter. The halide concentration is sufficient to promote adsorption of catalyst on the surface and eliminate bare spots in an adherent metal layer formed on the surface or on selected parts thereof. The halide solution is used in a pre-treatment step immediately followed by, or constituting part of, the solutions employed in the catalyzing sequence for rendering said surface receptive to the deposition of metal. The thus treated surface or selected parts thereof are exposed to a metal deposition bath solution to form a uniform metal layer thereon.

In US Application Serial No. 611,193 of May 21, 1984, is described another improvement in a process for metallizing ceramic substrates which includes treating the surface to adherently receive metal and depositing metal on the treated surface. The improved method comprises treating the surface with a melt comprising one or more alkali metal compounds to adhesion promote or etch the surface and, in a later step, exposing said surface to an adsorption promoter selected from the group consisting of quaternary compounds, ethyoxylated non-ionic compounds and nitrogen containing compounds. The nitrogen containing compounds are selected from the group consisting of quaternary compounds, amine oxides, alkanolamines, amides, betaines, amino acids and guanidine derivatives, and are in an amount sufficient to, and at a pH which will promote adsorption of catalyst on the surface and eliminate bare spots in an adherent metal layer formed on the surface or selected parts thereof. The adsorption promoter is used in a pre-treatment step immediately followed by, or constituting part of the solutions employed in the catalyzing sequence for rendering said surface receptive to the deposition of metal. The thus treated surface or selected parts thereof are exposed to a metal deposition bath solution to form a uniform metal layer thereon.

However, when the aforementioned procedures are used to deposit thick electrolessly deposited metal layers, blisters may form between the metal layer and the ceramic substrate. Blisters form, e.g., when copper layers are electrolessly deposited using plating solutions containing ethylenediaminetetraacetic acid (EDTA) as a complexing agent.

Surprisingly, it has been found that electrolessly formed blisterfree metal desposits of a thickness equal to or exceeding 2.5 $\mu$m, securely adhering to ceramic surfaces, can be formed on adhesion promoted ceramic surfaces by employing a process comprising treating the ceramic surface with the liquid composition resulting from heating a mixture comprising one or more alkali metal compound(s) and water to a temperature of from 140°C to 300°C and equal to or in excess of the melting point temperature of said mixture, said mixture comprising between 0.35 and 0.9 mole fractions of said alkali metal compound(s), for a time period sufficient for providing said ceramic surface with the desired surface topography.

The adhesion promoted ceramic surface obtained by using the process of this invention has a microfaceted structure, herein also referred to as surface topography, characterized by larger sized grains and a greater weight loss during adhesion promotion in comparison to a ceramic surface which has been adhesion promoted with the molten alkali metal compound alone under like conditions.

The present invention is directed to a process for electrolessly plating a metal layer on a ceramic substrate, such as alumina, which has excellent surface coverage and bond strength, i.e., at least 3 MPa, preferably at least 5 MPa as measured by the "dot pull" test described hereinafter.

The present invention also includes ceramic substrates having printed circuit patterns formed from such layers. Electrolessly deposited metal layers on ceramic substrates are obtained having a thickness of at least 2.5 μm, preferably at least 5 μm, and, in the case of printed circuit patterns, conductor features typically with a width as low as 25 μm, preferably 50 μm.

The process of the invention further comprises the steps of treating the adhesion promoted surface of the ceramic and contacting it with a solution capable of promoting adsorption of catalyst on the treated surface, rendering the treated surface receptive to electroless plating, and electrolessly depositing metal on the ceramic surface.

Fig. 1 is a scanning electron photomicrograph of the surface of a first ceramic substrate as described in Example 1 before adhesion promotion. The magnification is 1000x.

Fig. 2 is a scanning electron photomicrograph of the surface of a second ceramic substrate as described in Example 1 after adhesion promotion in sodium hydroxide at 450°C. The magnification is 1000x.

Fig. 3 is a scanning electron photomicrograph of the surface of a third ceramic substrate as described in Example 1 after adhesion promotion as described in the said Example. The magnification is 1000x.

Fig. 4 is a scanning electron photomicrograph of the ceramic surface of Fig. 1 at 2600x magnification.

Fig. 5 is a scanning electron photomicrograph of the ceramic surface of Fig. 3 at 2600x magnification.

In one aspect, the invention concerns a process for metallizing a ceramic substrate which comprises adhesion promoting a surface of the substrate with a liquid alkali metal compound of the invention, and subsequently electrolessly depositing a metal layer having a thickness greater

than 2.5 μm on the adhesion promoted surface without the formation of blisters between the metal layer and the ceramic surface. The adhesion promotion mixture of the invention is capable of modifying the interaction with the ceramic surface to provide a microfaceted surface structure with larger grain size and greater weight loss in comparison to an adhesion promoted ceramic surface provided by the use of the molten alkali metal compound alone under like conditions. The melting point of the mixture is sufficiently low for the adhesion promotion step to be performed at a temperature of from 140°C to 300°C and preferably from 145°C to 240°C. The ceramic surface is treated with the said liquid composition for a time period between 1 and 200 minutes.

After adhesion promoting the surface of the ceramic substrate and before forming the metal layer thereon, the surface is exposed to an acidic halide solution containing one or more halides selected from the group consisting of chlorides, bromides and iodides in an amount greater than 0.5 moles halide per liter and sufficient to promote adsorption of catalyst on the surface and eliminate bare spots in an adherent metal layer formed on the surface or on selected parts thereof, the solution being used in a pre-treatment step immediately followed by, or constituting part of, the solutions employed in the catalyzing sequence for rendering the surface receptive to metal deposition.

Alternately, after adhesion promot_ing the ceramic surface and before forming the metal layer thereon, the surface is exposed to an adsorption promoter selected from the group consisting of ethoxylated non-ionic compounds and nitrogen-containing compounds, the nitrogen containing compounds being selected from the group consisting of quaternary compounds, amine oxides, alkanolamines, amides, betaines, amino acids and guanidine derivatives, in an amount sufficient to, and at a pH which will promote adsorption of catalyst on the surface and eliminate bare spots in an adherent metal layer formed on the surface or selected parts thereof, the adsorption promoter being used in a pre-treatment step immediately followed by, or constituting part of, the solutions employed in the catalyzing sequence for rendering the surface receptive to metal deposition.

In another aspect, the invention concerns a process for producing a metal layer having a thickness greater that 2.5 μm on a surface of a ceramic substrate without blisters between the metal layer and the ceramic surface, which process comprises the steps of providing an alkali metal composition containing water and between 0.35 and 0.9 mole fractions of an alkali metal compound, heating said alkali metal composition at a temperature of between 145°C and 240°C to render it molten, contacting the ceramic surface with the heated, liquefied alkali metal composition for a time period sufficient to adhesion promote the ceramic surface, the mole fraction of said alkali metal compound present in the composition being selected to adjust the surface topography of the adhesion promoted surface so that grains of the metal which are to be subsequently deposited on the surface from an electroless metal plating bath adhere to the surface without the formation of blisters between the formed metal layer and the ceramic surface.

Any electrolessly platable metal may be deposited on the surface of a ceramic substrate in accordance with the invention. Typically, copper, nickel, silver or cobalt layers are electrolessly deposited.

The ceramic surface is first treated at a temperature between 140°C and 240°C with the liquid composition resultingt from heating a mixture comprising one or more alkali metal compound(s) and water, said mixture comprising from 0.35 to 0.9 mole fractions of said alkali metal compound(s) which will provide an etched surface necessary to create a strong bond between the metal layer electrolessly deposited and the ceramic substrate.

The preferred alkali metal compounds include sodium hydroxide, potassium hydroxide, sodium carbonate and potassium nitrate.

The melting point of the water and alkali metal compound(s) mixture may be depressed by dissolving up to 60% by weight, preferably up to 30% by weight, of low melting materials or even liquids in the mixture. Examples of such melting point depressants include stannous chloride, nitric acid, sodium and potassium formate, potassium acetate, Rochelle salts, borax, and the hydrates of lithium bromide, iodide and phosphate, and potassium pyrophosphate.

The most widely used electroless copper deposition solutions for depositing coherent thick layers of copper (from 5 μm to more than 75 μm) comprise EDTA as the complexing agent. With adhesion promotion processes of the prior art, blister formation has been observed when using such plating bath solutions.

Blisters are formed in copper layers as thin as 0.8 μm electrolessly deposited from a plating bath solution at 70 to 75°C comprising:

| | |
|---|---|
| Copper | 0.04 mol/l |
| EDTA | 0.12 mol/l |
| Formaldehyde | 0.05 mol/l |
| pH (at 25°C) | 11.5 - 11.8 |
| NaCN | 0.1 mmol/l |

Somewhat thicker copper layers may be deposited at lower temperatures without blister formation. The EDTA containing electroless copper deposition baths used at 55°C with 0.09 mol/l formaldehyde and at a pH of 12 (25°C) do, however, produce blistered copper layers at thicknesses as low as 1.6 μm.

When substrates are adhesion promoted by the procedure of the present invention, an adherent metal layer can be electrolessly deposited to any desired thickness without adhesion failures or blister formation between the metal layer and the ceramic substrate.

- 13 -

0185967

The metal coated ceramic substrates produced in accordance with the processes of the invention are useful for the production of etched printed wiring conductors on such substrates. The techniques for making etched printed wiring conductors on copper coated plastic substrates are well known in the art. These techniques may be applied to economically produce printed wiring circuits substituting for such plastic substrates the metal clad ceramic base materials made by the processes described herein.

In one embodiment of the invention, the ceramic base materials are adhesion promoted by immersion in a liquid composition of alkali metal hydroxides and water at temperatures in excess of 140°C, preferably in excess of 160°C, and for alumina substrates most preferably in excess of 170°C.

The temperature at which the ceramic base materials are adhesion promoted may be up to the boiling point of the alkali metal hydroxide/water mixture, preferably below 240°C, more preferably below 180°C, and for alumina substrates most preferably not exceeding 175°C.

The composition of the adhesion promotion solution can be varied from a mole fraction of 0.39 to 0.9 of the alkali metal compound, such as an alkali metal hydroxide. A mole fraction of 0.4 to 0.65 alkali metal compound is preferred, and most preferred is a mole fraction of 0.47 to 0.53 alkali metal compound.

The immersion time for adhesion promotion will vary with the temperature and composition of the adhesion promotion mixture and the composition of the substrate. Thus, for alumina substrates at 145°C, the adhesion promotion time will be from 2.5 to 8 hours and, e.g., at 0.5 mole fraction of alkali metal compound about 4.5 to 5.5 hours. At 160°C, the optimum immersion time for a composition comprising 0.5 mole fraction of alkali metal compound would be 10 to 45 minutes; at 170°C, the immersion time is from 5 to 15 minutes, and at 180°C from 3 to 8 minutes, and preferably 5 minutes for said 0.5 mole fraction composition. At 240°C,

- 14 -                    0185967

the mole fraction of alkali metal compound may be as high as 0.9 and the immersion time 1 minute or less. In order to get adequate wetting of the ceramic surface by the heated adhesion promotion composition, the substrate is dipped into the solution, removed, and then immediately returned for a total immersion time of 1 minute or less.

While not wishing to be bound by theory, it is believed that water acts as a modifier for enhanced ionization of the alkali metal compound and enhances the mobility of the alkali metal ion and its counter ion (e.g., hydroxide ion). The modification of the adhesion promotion compound results in a change in the surface grain structure of the ceramic substrate observed after adhesion promotion.

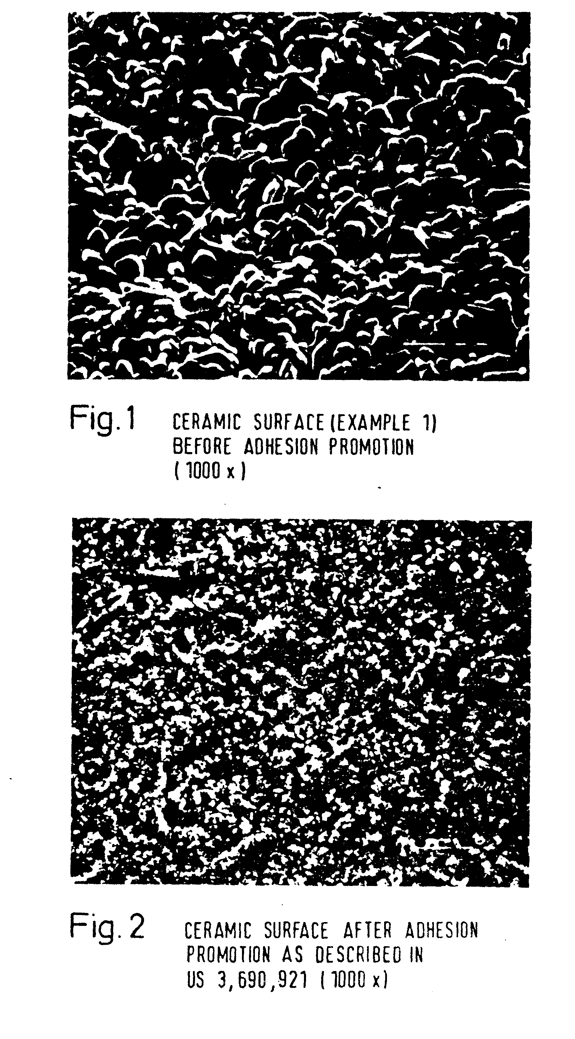

Fig. 1 shows the surface grains of an alumina substrate before adhesion promotion photographed by scanning electron microscopy at 1000x magnification.

Fig. 2 shows the surface grain structure of an identical substrate photographed by the same procedure after adhesion promotion by the immersion in molten sodium hydroxide at 450°C for 10 minutes as desribed in the prior art. The weight loss on 50 mm x 50 mm x 0.63 mm 96% alumina substrate was 0.15 to 0.25% by this procedure. The resulting surface is characterized by much smaller grains than the initial surface. When copper was electrolessly deposited on the surface, employing the plating solution described in the examples below, the copper blistered from the ceramic substrate.

Fig. 3 shows the surface grain structure of another identical substrate photographed by the same procedure after adhesion promotion as described in Example 1 hereinafter. This procedure produced a large grain, microfaceted surface. The weight loss was found to be 0.2 to 0.3%.

Fig. 4 shows the scanning electron micrograph of the ceramic surface of Fig. 1 before adhesion promotion at 2600x magnification, and Fig. 5 the surface of Fig. 3 after adhesion promotion at 2600x magnification.

As can be seen in Fig. 5, these microfaceted grains have etched steps (10) along the crystal planes of the grains, and etched sites (12) on the surfaces of the grains. Copper electrolessly deposited on this surface is free of blisters. (See Example 1 hereinafter).

Typical of the ceramic substrates treated by the composition comprising alkali metal compound(s) and water employed herein are aluminas, beryllias, titanates, forsterite, mullite, steatite, porcelains and mixtures of the foregoing.

Typical of the metal deposition solutions used are electroless plating solutions for nickel, cobalt, gold, copper and the like. Electrolytic metal deposition solutions also may be used in the practice of the invention, e.g., for applying corrosion resistant surface coatings.

In the processes described in US-PS 3 690 921, sodium hydroxide is rinsed from the ceramic surface with water, and then the ceramic surface is neutralized with dilute sulfuric acid and rinsed again before sensitizing it with stannous chloride, rinsing and seeding with palladium chloride to catalyze it for electroless metal plating. The prior art processes are unreliable and frequently result in incomplete surface coverage with electrolessly formed metal layers. Such condition is completely unsatisfactory for production. With prolonged immersion in both stannous chloride sensitizer and palladium chloride seeder solutions as well as incomplete rinsing steps, it sometimes may be possible to achieve complete surface coverage with metal. Such procedure is, however, not practical in production. Prolonged immersion in the sensitizer and seeder solutions prevents economical throughput of work, and incomplete rinsing after the stannous chloride sensitizing step leads to loosely adhering precipitate particles forming in the seeder- and in the electroless plating solution and to the rapid decomposition of these solutions.

Instead, acidic chloride, bromide and iodide solutions greater than 0.5 molar in halide concentration may be used to promote uniform adsorption on ceramic surfaces. These acidic halide solutions do not attack the glassy phase of the ceramic substrate.

The acidic chloride, bromide or iodide solution can be used as a pre-treatment or predip solution for the ceramic substrate after adhesion promotion, rinsing, neutralizing and rinsing again, and before treating with, e.g., stannous chloride sensitizer. After such pre-treatment, sensitizer is quickly adsorbed on the etched ceramic substrate. Immersion in the sensitizing solution need not be unduly prolonged. In addition, the tin species is so securely adsorbed that it is not inadvertently removed in a conventional rinsing step.

The acidic chloride, bromide or iodide pre-treatment solution preferably is greater than 2 molar in halide ion, and more preferably is greater than 3 molar in halide ion. The acidity of the halide solution preferably is greater than 0.001 molar in hydrogen ion, more preferably greater than 0.01 molar, and most preferably between 0.1 and 12 molar in hydrogen ion.

Alternatively, the chloride, bromide or iodide concentration of the sensitizer solution may be increased to accomplish the same desired effect, i.e., more strongly adsorbed sensitizer on the ceramic substrate. High acidity, however, inhibits adsorption of tin sensitizers. The ratio of the halide to acid in a stannous ion sensitizer solution is preferably at least 15 to 1. It is possible to use halide to acid ratios as low as 2 to 1, but these are not preferred because higher tin concentrations, i.e., 1 molar tin, are required.

Although it is not wished to be bound by theory, it is believed that in case of tin comprising solutions, the tin species which is adsorbed on the alumina is the tetrahalostannate(II)moiety. For example, high chloride ion concentration relative to acidity favors the formation of the tetrachlorostannate(II), while high acid concentration favors the formation of trichloro- and dichlorostannate(II) complexes.

When using a unitary catalyst solution comprising a chloride, bromide or iodide of palladium, tin and the halide acid or alkali metal halide salt without an acidic halide predip solution, the halide concentration in the catalyst solution may be varied over a range from 0.5 to 6 moles per liter, preferably greater than 1.5 moles per liter and less than 4 moles per liter. The acidity may be varied from 0.03 to 6 moles per liter, preferably greater than 0.3 and less than 4 moles per liter.

For greater processing latitude and to minimize processing errors, the acidic halide pre-treatments may be combined with a sensitizer solution formulated with the halide and acid concentrations described hereinbefore.

Furthermore, the acidic halide predip also may be used with a unitary catalyst solution.

By using an acidic halide predip, other catalytic precious or semi-precious metals may be adsorbed onto the ceramic surface amongst which are the Group IA metals, silver and gold and the other Group VIII precious metals.

Numerous processes are employed for the manufacture of printed circuit boards. As will be understood by those skilled in the art, these printed circuit manufacturing processes may be used in conjunction with the adhesion promoting step of this invention and with the step of rendering the ceramic surface receptive to metallization in order to produce metallized ceramic printed circuit boards.

Other modes of operation of this invention are, inter alia, disclosed in the Examples.


EXAMPLE 1

A ceramic substrate 75mm x 75mm x 0.63mm of 96% alumina was adhesion promoted by immersing it for 10 minutes in a solution of 70% (0.512 mole fractions) sodium hydroxide and 30% water at 172°C. The substrate was allowed to cool for 1 minute and then rinsed in water, rinsed in 35% sulfuric acid, and rinsed in water again.

The substrate was activated by the following procedure.

1.  Immerse for 1 minute in an aqueous conditioner solution containing an amphoteric surfactant (tallow betaine surfactant), a non-ionic surfactant (nonylphenoxypoly-ethoxyethanol) and ethanolamine. Adjust solution to a pH 2 with sulfuric acid.

2.  Rinse in water.

3.  Immerse for 1 minute in an aqueous halide predip solution of 3.8 moles sodium chloride, 0.1 moles hydrochloric acid, and 0.025 moles stannous chloride per liter.

4.  Immerse for 8 minutes in palladium-tin activator solution at 40°C. The activator was prepared by dissolving the concentrates prepared in accordance with US-PS 3 961 109 in a 3.8 molar sodium chloride solution and comprised palladium, 0.15 g/l; tin(II)chloride, 23 g/l; sodium chloride, 226 g/l; hydrogen chloride, 4.6 g/l; and resorcinol, 1.2 g/l.

5.  Rinse in water.

After activation, the substrate was plated at 75°C in an additive electroless copper plating solution having the following composition:

| | |
|---|---|
| Copper sulfate | 0.03 mol/l |
| EDTA | 0.09 mol/l |
| Formaldehyde | 0.05 mol/l |
| Sodium hydroxide to pH | 11.7 (at 25°C) |
| Sodium cyanide | 0.1 mmol/l |
| Sodium sulfate | 0.3  mol/l |
| Sodium formate | 0.6  mol/l |
| Surfactant (alkylphenoxypoly-ethoxyphosphate) | 0.01  g/l |

After a copper layer of 5 μm had been plated, the substrate was examined. The metal layer was uniformly attached to the substrate without blisters or other imperfections.

## EXAMPLE 2

Two alumina substrates were metallized by the procedure of Example 1 except that both were adhesion promoted for 20 minutes. One was adhesion promoted at 150°C and the other at 164°C. Also, electroless deposition of copper was continued to a thickness of 28 µm.

The copper deposit on the substrate was uniform and free of blisters. The copper surfaces were then imaged and the copper etched by conventional photolithographic techniques to produce copper dots 1.9 mm in diameter. The adhesion of the copper to the ceramic substrate was measured by the "dot pull" test. Wires were attached to the copper dots with solder and the force required to separate the dots from the substrate was measured. The results were as follows:

| Adhesion Promotion Temperature | Bond Strength |
|---|---|
| 150°C | 6.9 MPa |
| 164°C | 21.4 MPa |

## EXAMPLE 3

Three 96% alumina substrates were adhesion promoted by immersion in molten sodium hydroxide/water mixtures for 5 minutes as followd:

| Substrate | Time | Temperature | NaOH | Mole fractions |
|---|---|---|---|---|
| A | 5 min. | 170°C | 70% | 0.51 |
| B | 5 min. | 180°C | 70% | 0.51 |
| C | 5 min. | 195°C | 76% | 0.54 |

The substrates were rinsed and neutralized as in Example 1. Then, the substrates were activated as in Example 1, except that the activator solution used was a palladium-tin activator solution containing 3.5 molar hydrochloric acid instead of 3.8 molar sodium chloride.

After activation, the substrates were plated with a 28 µm thick layer of copper in the electroless copper plating solution of Example 1. The copper layers deposited on all three substrates had good adhesion to the substrates, and

- 20 -                    0185967

there was no blistering of the copper layers from the substrates.

<div align="center">EXAMPLE 4</div>

Example 1 was repeated except that adhesion promotion was accomplished by immersion for 20 minutes in a solution of 60% (0.403 mole fractions) sodium hydroxide and 40% water at 150°C. The copper deposit was plated to a thickness of 28 μm. The adhesion of the copper layer to the alumina substrate was good and there were no blisters between the copper layer and the substrate.

<div align="center">EXAMPLE 5</div>

Example 1 was repeated except that for activation, the activating solution of Example 2 was used, and for metal deposition a nickel phosphorous electroless plating solution operating at 80°C to plate a nickel layer 12 μm thick on the adhesion promoted and activated alumina substrate. The nickel deposit had good adhesion to the ceramic substrate and there were no blisters between the nickel layer and the substrate.

<div align="center">EXAMPLE 6</div>

A ceramic substrate 75 x 75 x 0.63 mm of 99% alumina was adhesion promoted for 10 minutes at 180°C in a solution of 72% (0.536 mole fractions) sodium hydroxide and 28% water. It was neutralized, activated and plated by the procedures of Example 1, except that a copper layer of 28 μm was deposited on the substrate. The copper layer uniformly adhered to the substrate with no blisters between the copper layer and the substrate.

<div align="center">EXAMPLE 7</div>

The procedure of Example 6 was repeated except that the ceramic substrate was 90% alumina and the adhesion promotion was at 165°C in a solution of 70% (0.512 mole fractions) sodium hydroxide and 30% water. The results were the same.

## EXAMPLE 8

A group of ceramic substrates were provided with copper surface layers by the procedure of Example 1. The adhesion of the copper layer to the surface was tested by the "dot pull" test of Example 2. The average adhesion of the copper layer to the substrate was 13 MPa.

## EXAMPLE 9

Example 1 was repeated on additional substrates except that they were plated with electrolessly deposited copper layers ranging from 2.5 to 50 μm in thickness. All copper layers had good adhesion to the substrates without any evidence of copper blistering from the ceramic surface. The average bond strength measured by the dot pull test was greater than 12.5 MPa and independent of metal thickness.

## EXAMPLE 10

Example 1 was repeated except that the copper layer was deposited to a thickness of 75 μm. The copper layer had good adhesion without any evidence of copper blistering from the ceramic substrate.

CLAIMS:

1.    A process for electrolessly forming a securely adhering, blisterfree metal deposit of a thickness equal to or exceeding 2.5 μm on an adhesion promoted surface of a ceramic substrate, characterized in that said process comprises adhesion promoting said surface by treating it with the liquid composition resulting from heating a mixture comprising one or more alkali metal compound(s) and water to a temperature of from 140°C to 300°C and equal to or in excess of the melting point temperature of said mixture, said mixture comprising between 0.35 and 0.9 mole fractions of said alkali metal compound(s), for a time period sufficient for providing said ceramic surface with the desired surface topography.

2.    The process of claim 1, characterized in that the treatment of the ceramic surface is performed at a temperature between 140°C and 240°C for a time period between 1 and 200 minutes.

3.    The process of claim 1, characterized in that said mixture comprises 10 to 40% of water and said treatment temperature is between 160° and 180°C, preferably between 165°C and 175°C, and the treatment time is from 3 to 45 minutes, and preferably from 5 to 15 minutes.

4.    The process of one or more of claims 1 to 3, characterized in that the alkali metal compound(s) is (are) NaOH or KOH or a mixture of both.

5.    The process of one or more of claims 1 to 4, characterized in that the adhesion promoted surface, prior to forming the metal layer thereon, is exposed to an acidic halide solution containing one or more halide(s) selected from chlorides, bromides, iodides in an amount greater than 0.5 mol/l, said solution being used in a pre-treatment step immediately followed by or constituting part of the treatment with a solution for rendering the ceramic surface receptive to metal deposition.

6.        The process of one or more of claims 1 to 4, characterized in that the adhesion promoted surface, prior to forming the metal layer, is exposed to a solution comprising one or more compound(s) selected from ethoxylated non-ionic compounds, nitrogen containing compounds selected from the group of quaternary compounds, amine-oxides, alkanolamines, amides and betaines, amino acids and guanidine derivatives, said solution being used in a pre-treatment step immediately followed by or constituting part of the treatment with a solution for rendering the ceramic surface receptive to metal deposition.

7.        The process of one or more of claims 1 to 6, characterized in that the mole fraction of said alkali metal compound(s) is selected to adjust the surface topography of the adhesion promoted ceramic surface so that grains of the metal subsequently deposited securely adhere to the surface and a blisterfree metal layer is formed.

8.        The process of one or more of claims 1 to 7, characterized in that the metal deposited has a thickness of from 5 to 75 μm.

9.        An article comprising a ceramic substrate with a securely adhering, blisterfree metal coating covering at least part of the ceramic surface and made by the process of one or more of claims 1 to 8.

Fig. 1    CERAMIC SURFACE (EXAMPLE 1)
          BEFORE ADHESION PROMOTION
          ( 1000 x )

Fig. 2    CERAMIC SURFACE AFTER ADHESION
          PROMOTION AS DESCRIBED IN
          US 3,690,921 ( 1000 x)

Fig. 3    CERAMIC SURFACE AFTER ADHESION
          PROMOTION AS PER EXAMPLE 1
          ( 1000 x )

Fig. 4    SAME SURFACE AS IN FIG. 1
          (2600 MAGNIFICATION)

Fig. 5   SAME SURFACE AS IN FIG.3
(2600 MAGNIFICATION)